## Europäisches Patentamt

## European Patent Office

## Office européen des brevets

(11) Publication number: **0 063 356**
**B1**

## EUROPEAN PATENT SPECIFICATION

(45) Date of publication of patent specification: **14.10.87**

(51) Int. Cl.⁴: **G 01 R 19/165**

(21) Application number: **82103132.5**

(22) Date of filing: **14.04.82**

(54) Time switch arrangement.

(30) Priority: **16.04.81 JP 58201/81**

(43) Date of publication of application:
**27.10.82 Bulletin 82/43**

(45) Publication of the grant of the patent:
**14.10.87 Bulletin 87/42**

(84) Designated Contracting States:
**DE FR IT**

(56) References cited:
**DE-A-2 751 836**
**FR-A-2 267 554**

**TOUTE L'ELECTRONIQUE, no.440, February
1979 "Testeur de tension secteur" page 61
FUNKSCHAU, vol.51, no.19, September 1979,
P. VON BECHEM:"Unterspannungsanzeige",
page 1131**

**IBM TECHNICAL DISCLOSURE BULLETIN,
vol.19, no.8, January 1977, IBM Corp., New
York (US) B.P. FENTON et al.: "AC current
detector circuit", page 3227**

**ELECTRONICS INTERNATIONAL, vol.50, no.19,
September 1977 R.J.PATEL :"555 timer isolates
equipment from excessive line voltage", page
116**

(73) Proprietor: **MITSUBISHI DENKI KABUSHIKI
KAISHA**
**2-3, Marunouchi 2-chome Chiyoda-ku
Tokyo 100 (JP)**

(72) Inventor: **Kouzai, Fumio c/o Mitsubishi Denki
K.K.**
**Fukuyama Works 1-8, Midorimachi
Fukuyama-shi Hiroshima (JP)**
Inventor: **Motoki, Yoshiaki Mitsubishi Denki
K.K.**
**Fukuyama Works 1-8, Midorimachi
Fukuyama-shi Hiroshima (JP)**

(74) Representative: **Eisenführ & Speiser
Martinistrasse 24
D-2800 Bremen 1 (DE)**

Courier Press, Leamington Spa, England.

## Description

### Field of the Invention

This invention relates to a time switch arrangement to be operated on either one of two selected mains voltages, including a motor driving circuit, a dc converting circuit for dropping, rectifying and smoothing the mains voltage, a path through which current generated by the converting circuit flows to the motor driving circuit, and a voltage indication circuit for detecting the presence of an output voltage of said dc converting circuit.

### Description of the Prior Art

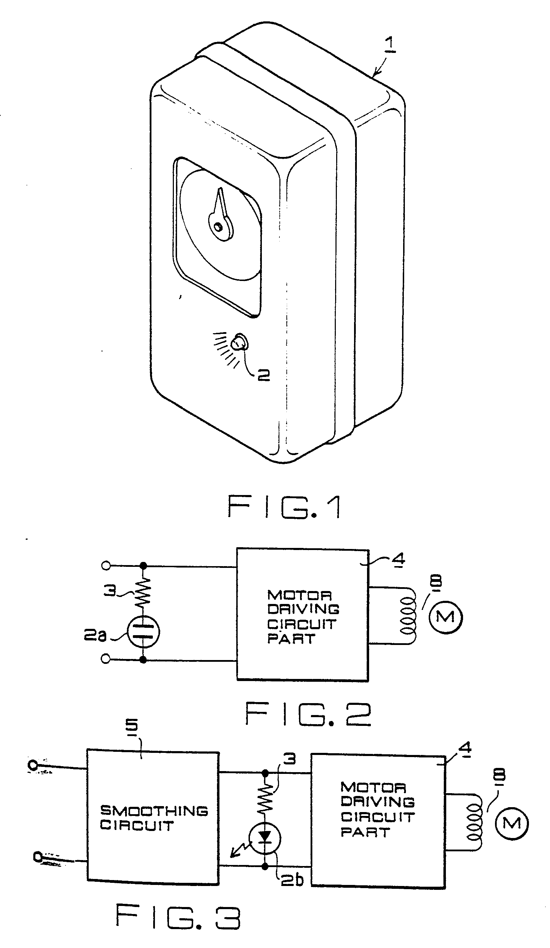

In order to normally operate a time switch, it is required that appropriate electric power is supplied to it. It is desired to easily discriminate whether the time switch is energized or not at the time of operating the connection of load, or of setting the time to be switched. For this reason, an energization indicator lamp 2 is generally utilized in a known time switch 1 as shown in Figure 1.

Heretofore circuits shown in Figures 2 and 3 have been proposed as energization indicating circuits for such type of indicator as stated above.

Namely, Figure 2 shows an example in which a neon lamp 2a is used as such energization indicator lamp. In the circuit shown in Figure 2, a current limitation resistance 3 is connected to the neon lamp 2a, and further a motor driving circuit 4 is connected in parallel, driving a motor 8 for the time switch.

Moreover Figure 3 shows another example in which a light emission diode 2b is utilized as the energization indicator lamp. In the circuit shown in Figure 3, a circuit 5 for dropping, rectifying and smoothing the mains voltage is provided with a current limitation resistance 3 and a light emission diode 2b at the output side thereof. In this arrangement, the output of the smoothing circuit 5 supplies electric power to a motor driving circuit part 4 and at the same time, supplies the electric power to the light emission diode 2b to emit light.

In the conventional examples as shown in Figures 2 and 3, if electric power is supplied to the time switch 1, the energization indicator lamp 2 remains lit. By such lighting, it is indicated that the time switch 1 is normally operated.

However, such conventional energization indicator has the disadvantage that it indicates only the presence of power supply upon the time switch 1. If the time switch is to be operated on either one of two selected mains voltages, i.e. 100V or 200V, it is impossible to discriminate whether the voltage now applied is 100V or 200V. In these circumstances, a label indicating the applied voltage had heretofore to be stuck on the time switch in order to discriminate the voltage applied. Theretofore a troublesome operation such as renewal of the label has been required in the case where there is a change in the provision of the time switch so that the voltage supplied thereto also changes. Besides there is a risk of accidents due to mistakes such as such label being missing from the time switch, and erroneous application of a label thereon.

### Summary of the Invention

It is an object of the present invention to provide a time switch to be operated on either one of two selected mains voltages, in which it is clearly and automatically indicated which one of the two selected mains voltages has been applied, and whether the mains voltage is applied or not.

From DE—A—27 51 836 a battery monitoring circuit is known which comprises a voltage discriminating circuit for detecting and indicating undervoltage and overvoltage as well as correct voltage conditions. This known circuit uses a combination of two zener diodes and two transistors. This circuit is suitable for monitoring one voltage only, but it cannot be used for indicating to which one of two selected mains voltages an apparatus such as a time switch is connected.

For solving this object the present invention is characterized in that said path comprises two parallel connected paths the first of which includes an element emitting light of a first colour and the second of which includes an element emitting light of a second colour, and in that the voltage indication circuit comprises a voltage detection circuit for discriminating between the two different levels of output voltage of said dc converting circuit corresponding to operation on the two selected mains voltages to generate an output signal at one of two discrete levels, the level of this signal determining the state of a switch which in turn determines through which one of said first and second paths the output current of the dc converting circuit flows to the motor driving circuit.

A preferred embodiment of the invention is characterized in that said voltage detection circuit comprises a zener diode. As light emission elements preferably a two-color light emission diode is used, it is also possible to use two separate light emission diodes each having a different color from the other.

The invention will now be described by way of example in connection with the accompanying drawings.

### Brief Description of the Drawings

Figure 1 is a perspective view showing an outline of a time switch provided with an energization indicator lamp;

Figure 2 and 3 are circuit diagrams each showing a conventional energization indicator lamp;

Figure 4 is a block diagram showing an embodiment of a time switch circuit according to the present invention; and

Figure 5 is a specific circuit diagram of Figure 4.

### Preferred Embodiment of this Invention

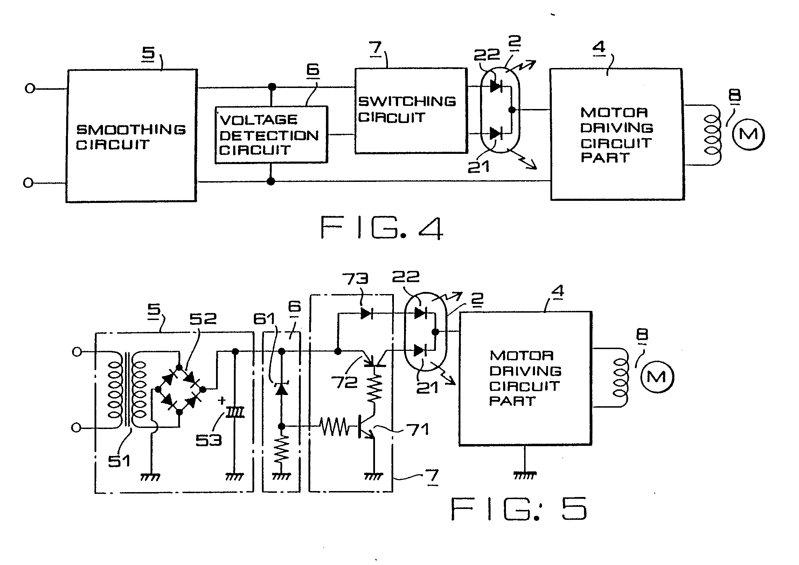

A preferred embodiment of this invention will now be described hereinbelow by referring to Figures 4 and 5, respectively, wherein the identical reference numerals designate the corresponding parts to those of Figures 1—3, respectively. A voltage detection circuit 6 is connected with the output side of a circuit 5 for dropping, rectifying and smoothing voltage (or dropping, rectifying and smoothing circuit) for commercial power source in parallel thereto. Output of the voltage detection circuit 6 is supplied to a switching circuit 7. An energization indicator lamp 2 is connected to the output side of the switching circuit 7. The energization indicator lamp 2 consists of a two-color light emission diode fabricated through integration of a red light emission diode 21 and a green light emission diode 22 by means of cathode common manner. A motor driving circuit part 4 comprises an oscillation circuit, dividing circuit, output amplifier circuit, battery charging circuit for compensating power off and the like and the motor driving circuit part 4 is such that a constant voltage is applied to a driving motor 8 for time switch irrespective of supply voltage. Further the aforesaid dropping, rectifying and smoothing circuit 5 comprises, as shown in Figure 5, a dropping transformer 51, a rectifier bridge 52 and an electrolytic condenser 53. In addition, the voltage detection circuit 6 comprises a Zener diode 61. Besides the switching circuit 7 comprises transistors 71 and 72 as well as another diode 73.

Next, operations of the above stated circuits will be described hereinbelow. The voltage dropped by means of the transformer 51 is rectified and smoothed by means of the rectifier bridge 52 and the electrolytic condenser 53 to become dc voltage. The resulting dc voltage is supplied to cathode terminal of the Zener diode 61 in the detection circuit 6. The sum of Zener voltage $V_z$ in the Zener diode 61 and voltage $V_{BE}$ across he base and emitter of the transistor 71 is set to a substantially intermediate value between the output voltage in the case when supply voltage upon the time switch is 100V and the output voltage in the case when such supply voltage is 200V. Accordingly when the supply voltage upon the time switch 1 is 100V, dc output voltage from the dropping, rectifying and smoothing circuit 5 becomes lower than the aforesaid sum voltage $V_z + V_{BE}$, so that it does not cause the Zener diode 61 to conduct. As a consequence, both the transistors 71 and 72 are OFF so that the electric power from the dropping, rectifying and smoothing circuit 5 is supplied from the diode 73 to the motor driving circuit part 4 through the insulated light emission diode 22. In other words, when such supply voltage is 100V, the energization indicator lamp 2 emits green light. On the other hand, when the supply voltage upon the time switch 1 is 200V, the output voltage derived from the dropping, rectifying and smoothing circuit 5 comes to be higher than the aforesaid sum voltage $V_z + V_B$, so that it causes the Zener diode 61 to conduct. Upon conduction of the aforesaid Zener diode 61, the aforesaid transistors 71 and 72 come to be ON. The voltage sum of collector-emitter saturation voltage $V_{CE(Sat)}$ of the aforesaid transistor 72 and forward voltage $V_F$ of the red light emission diode is set at a lower value than the sum voltage of forward voltage $V_F$ of the diode 73 and forward voltage $V_F$ of the green light emission diode. Consequently, when the aforesaid transistor 72 becomes ON, the electric power from the dropping, rectifying and smoothing circuit 5 is supplied from the above transistor 72 to the motor driving circuit part 4 through the red light emission diode 21. Thus, when such supply voltage is 200 volt, the energization indicator lamp 2 emits red light.

As described above, the present invention is constructed in such a way that a two-color light emission diode is utilized as the energization indicator lamp 2, and the color of light emission is switched in response to either high or low supply voltage upon the time switch 1. As a result, the presence of energization may be discriminated, and the difference of voltage energized easily confirmed. Accordingly, in accordance with such construction of the present invention, a two-way voltage type time switch having high safety can be obtained.

In addition, if the Zener voltage in the Zener diode 61 is selected at a suitable value, it is also possible to check the voltage supplied to the time switch 1 and to easily discriminate whether the voltage supplied to the motor driving circuit part is normal or abnormal.

In the above embodiment, although the reference is made to the case where the two-color light emission diode is utilized, it is to be understood that the present invention can attain similar advantages to those of the embodiment, even if separate light emission diodes each having a different color from one another are independently used.

**Claims**

1. A time switch arrangement to be operated on either one of two selected mains voltages, including a motor driving circuit (4) for energising a motor (M), a dc converting circuit (5) for dropping, rectifying and smoothing the mains voltage, a path through which current generated by the converting circuit flows to the motor-driving circuit and a voltage indication circuit (6, 7, 2) for detecting the presence of an output voltage of said dc converting circuit, characterised in that said path comprises two parallel connected paths (72, 21; 73, 22) the first of which includes an element (21) emitting light of a first colour and the second of which includes an element (22) emitting light of a second colour, and in that the voltage indication circuit (6, 7, 2) comprises a voltage detection circuit (6) for discriminating between the two different levels of output voltage of said dc converting circuit corresponding to operation on the two selected mains voltages to generate an output signal at one of two discrete levels, the level of this signal determining the state of a switch (71, 72) which in turn determines through which one of said first and second paths the output current of the dc converting circuit flows to the motor driving circuit.

2. An arrangement as claimed in Claim 1, wherein said first current path is provided by a transistor (72) in series with said element (21) emitting light of said first colour, the transistor (72) being switched into its conductive state by the voltage detection circuit (6) in response to the higher output voltage of the dc converting circuit (5), and being switched into its blocking state in response to the lower output voltage; and wherein said second current path includes the element (22) emitting light of said second colour.

3. An arrangement as claimed in Claim 1 or 2, wherein said voltage detection circuit (6) comprises a Zener diode (61).

4. An arrangement as claimed in Claim 1, wherein said light emission elements together form a two-colour light emission diode (2).

5. An arrangement as claimed in Claim 1, wherein said light emission elements consist of separate light emission diodes (21, 22).

## Patentansprüche

1. Zeitschaltervorrichtung, die entweder an der einen oder anderen zweier ausgewählter Netzspannungen zu betreiben ist; mit einem Motorspeisekreis (4) zum Versorgen eines Motors (M); mit einem Gleichspannungs-Wandler-Kreis (5) zum Erniedrigen, Gleichrichten und Sieben der Netzspannung; mit einem Stromkreis, durch den der in dem Wandlerkreis erzeugte Strom dem Motorspeisekreis und einem Spannungs-Anzeigekreis (6, 7, 2) zum Anzeigen des Vorhandenseins einer Ausgangsspannung des Gleichspannungs-Wandlerkreises zugeleitet wird; dadurch gekennzeichnet, daß der Stromkreis zwei parallel geschaltete Strompfade (72, 21; 73, 22) enthält, von denen der erste ein Licht emittierendes Element (21) erster Farbe und der zweite ein Licht emittierendes Element (22) zweiter Farbe enthält; daß der Spannungs-Anzeigekreis (6, 7, 2) einen Spannungsmeßkreis (6) zum Unterscheiden zwischen den beiden unterschiedlichen Pegeln der Ausgangsspannung des Gleichspannungs-Wandlerkreises enthält, die sich im Betrieb an den beiden ausgewählten Netzspannungen einstellen, um ein Ausgangssignal bei einem der beiden diskreten Pegel zu erzeugen; und daß der Pegel dieses Signals den Zustand eines Schalters (71, 72) bestimmt, der wiederum festlegt, durch welchen der ersten und zweiten Strompfade der Ausgangsstrom des Gleichspannungs-Wandlerkreises zum Motorspeisekreis fließt.

2. Vorrichtung nach Anspruch 1, dadurch gekennzeichnet, daß der erste Strompfad durch einen Transistor (72) gebildet wird, der in Serie mit dem Licht emittierenden Element (21) erster Farbe liegt; daß der Transistor (72) durch den Spannungsmeßkreis (6) bei der höheren Ausgangsspannung des Gleichspannungs-Wandlerkreises (5) in den leitenden Zustand und bei der niedrigeren Ausgangsspannung in den gesperrten Zustand geschaltet wird; und daß der zweite Strompfad das Licht emittierende Element (22) zweiter Farbe enthält.

3. Vorrichtung nach Anspruch 1 oder 2, dadurch gekennzeichnet, daß der Spannungsmeßkreis (6) eine Zenerdiode (61) enthält.

4. Vorrichtung nach Anspruch 1, dadurch gekennzeichnet, daß die Licht emittierenden Elemente zusammen eine Zweifarben-Leuchtdiode (2) bilden.

5. Vorrichtung nach Anspruch 1, dadurch gekennzeichnet, daß die Licht emittierenden Elemente zwei getrennte Leuchtdioden (21, 22) sind.

## Revendications

1. Ensemble formant minuterie, destiné à fonctionner sur l'une ou l'autre de deux tensions sélectionnées du réseau et comprenant un circuit (4) de commande de moteur permettant d'exciter un moteur (M), un circuit (5) de conversion en courant continu servant à abaisser, redresser et lisser la tension du réseau, une voie qu'emprunte le courant produit par le circuit de conversion pour aboutir au circuit de commande du moteur, et un circuit (6, 7, 2) d'indication de tension, servant à détecter la présence d'une tension à la sortie dudit circuit de conversion en courant continu, caractérisé en ce que ladite voie comporte deux branches raccordées en parallèle (72, 21; 73, 22), dont la première renferme un élément (21) émettant une lumière possédant une première couleur et dont la seconde contient un élément (22) émettant une lumière possédant une seconde couleur, et en ce que le circuit (6, 7, 2) d'indication de tension comprend un circuit (6) de détection de tension, qui sert à établir une distinction entre les deux niveaux différents de la tension de sortie dudit circuit de conversion en courant continu correspondant au fonctionnement sur les deux tensions sélectionnées du réseau, de manière à produire un signal de sortie possédant l'un des deux niveaux distincts, le niveau de ce signal déterminant l'état d'un commutateur (71, 72), qui à son tour détermine laquelle des première et seconde branches, le courant de sortie du circuit de conversion en courant continu emprunte pour aboutir au circuit de commande du moteur.

2. Ensemble selon la revendication 1, dans lequel ladite première branche pour le courant est formée par un transistor (72) monté en série avec ledit élément (21) émettant la lumière possédant ladite première couleur, le transistor (72) étant commuté dans son état conducteur par le circuit (6) de détection de tension, en réponse à la tension de sortie la plus élevée du circuit (5) de conversion en courant continu, et étant commuté dans son état de blocage en réponse à la tension de sortie la plus basse; et dans lequel ladite seconde branche pour le courant contient l'élément (22) émettant la lumière possédant ladite seconde couleur.

3. Ensemble selon la revendication 1 ou 2, dans lequel ledit circuit (6) de détection de tension comporte une diode Zener (61).

4. Ensemble selon la revendication 1, dans lequel lesdits éléments émetteurs de lumière forment ensemble une diode (2) émettant des lumières de deux couleurs.

5. Ensemble selon la revendication 1, dans lequel lesdits éléments émetteurs de lumière sont constitués par des diodes photoémissives séparées (21, 22).

F I G . 1

F I G . 2

F I G . 3

1

0 063 356

FIG. 4

SMOOTHING CIRCUIT — 5

VOLTAGE DETECTION CIRCUIT — 6

SWITCHING CIRCUIT — 7

MOTOR DRIVING CIRCUIT PART — 4

M — 8

22 2 21

FIG. 5

SMOOTHING CIRCUIT 5, 51, 52, 53

61 6

73 22 2 21

72 71 7

MOTOR DRIVING CIRCUIT PART — 4

M — 8